# EUROPEAN PATENT SPECIFICATION

(11) **EP 1 951 829 B1**
(45) Date of publication and mention of the grant of the patent: **09.12.2009**
(21) Application number: 06794016.3
(22) Date of filing: 13.10.2006
(51) Int. Cl.: C09D 129/00, C09D 131/04, G03F 7/00

(54) **WATER CASTABLE - WATER STRIPPABLE TOP COATS FOR 193 NM IMMERSION LITHOGRAPHY**
WÄSSRIGE SOWOHL AUFTRAG- ALS AUCH WIEDERABZIEHBARE DECKSCHICHTEN FÜR DIE IMMERSIONSLITHOGRAPHIE BEI 193 NM
COUCHE SUPERIEURE COULABLE DANS L'EAU ET PELABLE DANS L'EAU POUR LITHOGRAPHIE PAR IMMERSION A 193 NM

(30) Priority: 21.11.2005 US 284358
(43) Date of publication of application: 06.08.2008
(73) Proprietor: International Business Machines Corporation, Armonk, NY 10504 (US)
(72) Inventor: BROCK, Philip, Joe, Sunnyvale, CA 94086 (US); CHA, Jennifer, Hampshire, SO21 2JN (GB); GIL, Dario, Pleasantville, NY 10570 (US); LARSON, Carl, Eric, San Jose, CA 95123 (US); SUNDBERG, Linda, Karin, Los Gatos, CA 95032 (US); WALLRAFF, Gregory, Morgan Hill, CA 95037 (US)
(74) Representative: Burt, Roger James
(86) International application number: PCT/EP2006/067371
(87) International publication number: WO 2007/057263

(56) References cited:
- EP-A2- 0 352 630
- US-A1- 2005 239 296

## Description

### Field of the Invention

This invention relates to a topcoat material and the use thereof in lithographic processes. More particularly, this invention is directed to a topcoat material comprising a polymer which is sparingly soluble or insoluble in water at a temperature of 25°C or below, but soluble in water at a temperature of 60°C or above. The inventive topcoat material is especially useful for immersion lithography in which a liquid, such as water, is used as the exposure medium between the lens fixture of an exposure tool and the photoresist-coated wafer. The topcoat material of the present invention is also useful for immersion lithography employing immersion medium other than water.

### Background of the Invention

The continuous drive to print smaller structures for advanced electronic device manufacturing requires the use of higher resolution optical lithography tools. Immersion lithography offers the potential to extend current 193 nm argon fluoride-based technology to 45 nm critical dimensions (half-pitch DRAM) and beyond by effectively improving the depth-of-focus processing window for a given optical numerical aperture (NA). The process requires filling the gap between the last lens element of the exposure tool and the resist-coated substrate with ultra-pure water. Use of a medium with an index of refraction higher than air results in a greater numerical aperture (NA), and therefore allows printing of smaller features. See "Technology Backgrounder: Immersion Lithography," published by ICKnowledge.com at. http://www.icknowledge.com, May 28, 2003. See also L. Geppert, "Chip Making's Wet New World," IEEE Spectrum, Vol. 41, Issue 5, May 2004, pp. 29-33; and M. Slezak, "Exploring the needs and tradeoffs for immersion resist topcoating", Solid State Technology, Vol.47, Issue 7, July 2004. In addition, immersion lithography results in an increased resolution of optical scanners since it enables lens designs with NA greater than 1.0. See A. Hand, "Tricks With Water and Light: 193 nm Extension", Semiconductor International, Vol.27, Issue 2, February 2004.

One of the technical challenges facing liquid immersion lithography is the diffusion between the photoresist components and the immersion medium. That is, during the immersion lithographic process, the photoresist components leach into the immersion medium and the immersion medium permeates into the photoresist film. Such diffusion is detrimental to photoresist performance and might result in disastrous lens damage or contamination in a 40 million dollar lithography tool. Topcoat materials can be applied on top of the photoresist layer for the purpose of reducing or eliminating the diffusion between the photoresist film and the exposure medium.

Traditionally, topcoat materials have been used in photolithography as anti-reflective films on top of a photoresist. The top anti-reflective coat (TARC) materials can prevent the multiple interference of light that takes place within the photoresist layer during exposure. As a result, the critical dimension (CD) variation of the geometrical features of a photoresist pattern caused by the variation in the thickness of the photoresist film can be minimized. To fully take advantage of the anti-reflective effect of the topcoat, the refractive index of the topcoat material (nₜ) should be at about the square root of the product of the refractive index of the exposure medium (nₘ) and the refractive index of the underlying photoresist (nᵣ). If the exposure medium is air, as in the case for "dry" lithography, the optimal refractive index of the topcoat material (nₜ) should be at about the square root of the refractive index of the underlying photoresist (nᵣ) since the refractive index of air is roughly 1.

For ease of processing, classic TARC materials are designed to be soluble in both water and aqueous base developers so that they can be applied directly from a water solution and subsequently removed by an aqueous base developer during the develop stage.

Numerous topcoat materials have been developed to meet these two requirements of optimal refractive index and solubility. For example, U.S. Patent Nos. 5,744,537 and 6,057,080 disclose aqueous-soluble TARC materials comprising a polymeric binder and a fluorocarbon compound which have nearly ideal refractive indices on the order of 1.3-1.4. U.S. Patent No. 5,879,853 also discloses a TARC material that is removable by a wet process. U.S. Patent No. 5,595,861 similarly discloses a TARC comprising partially fluorinated compounds which can also be water soluble. U.S. Patent No. 6,274,295 discloses a TARC material comprising a light absorbing compound having a wavelength of maximum absorption higher than an exposure wavelength used to expose the photoresist. This TARC can also be water-soluble. Finally, U.S. Patent No. 5,240,812 discloses a protective material for use as an overcoat film for acid catalyzed resist compositions to prevent contamination from vapors of organic and inorganic bases. While not specifically disclosed as being a TARC, the overcoat can also be water soluble. US 2005 /239296 A1 and EP 0352630 A2 disclose further cover layer and TARC materials respectively.

Since water is used in the first generation immersion tools as the exposure medium for 193 nm immersion lithography, classic water-soluble TARC materials such as those described above cannot be used as topcoats for such technology. The currently used water-insoluble protective topcoats for 193 nm immersion lithography employ organic casting solvents that are stripped in either aqueous base developers or organic stripping solvents. Some of the organic casting solvents are flammable, and are thus not suitable for the large-scale production, such as in the manufacture of semiconductors. Further, the use of organic casting solvents can result in intermixing of the topcoat and the resist film, thereby causing degradation of the photoresist. Moreover, the use of these solvents adds considerable process complexity and cost to integrated circuit (IC) manufacturing. Other commercial materials currently available either require solvents that are incompatible with semiconductor fabrication lines or impact the lithographic performance of the photoresist. It is therefore highly desirable to extend the standard water castable topcoat processing techniques that are currently employed in "dry" lithography to 193 nm immersion lithography for use with either water or alternative immersion fluids.

Thus, there remains a need for a topcoat material that is water castable, water strippable, compatible with photoresist. Ideally, the topcoat material also has the desired optical properties so that it can also be used as a TARC. The use of water processable topcoat material avoids the use of organic casting solvents and results in simplified resist processing and lower production cost.

### Summary of the Invention

The topcoat material of the present invention is water castable, water strippable, and useful for 193 nm immersion lithography. The topcoat material of the present invention is also useful for immersion lithography employing immersion medium other than water. Such immersion medium includes an organic liquid comprised of a hydrocarbon or a substituted hydrocarbon.

Accordingly, the present invention is directed to a topcoat material for application on top of a photoresist layer. The present invention provides a topcoat material for 193 nm immersion lithography for applying on top of a photoresist layer, comprising a polymer which is sparingly soluble or insoluble in water at a temperature of 25°C or below, but soluble in water at a temperature of 60°C or above, wherein sparingly soluble denotes that less than 1 weight percent and greater than 0.1 weight percent polymer dissolves in water, insoluble denotes solubility less than sparingly soluble, and soluble denotes that greater than 5 weight percent of polymer will dissolve in water, wherein the polymer comprises poly vinyl alcohol monomer units and poly vinyl acetate or polyvinyl ether monomer units providing the following polymer structure: 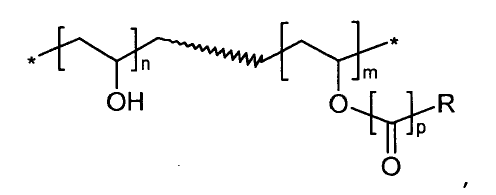 wherein R is an aliphatic or alicyclic radical; m and n are independently integers, and are the same or different; and p is zero or 1. comprises a polymer which is sparingly soluble or insoluble in water at a temperature of 25°C or below, but soluble in water at a temperature of 60°C or above.

In another aspect, the present invention is directed to a method of forming a patterned material layer on a substrate. Accordingly the present invention further provides a method of forming a patterned material layer on a substrate, the method comprising: providing a substrate having a material layer on a surface thereof; depositing a photoresist composition on the substrate to form a photoresist layer on the material; applying a topcoat material as described in the preceding paragraph on top of the photoresist layer, thereby forming a coated substrate; pattern-wise exposing the coated substrate to an imaging radiation; contacting the coated substrate with water at a temperature of about 60°C or above, wherein the top coat material is removed from the coated substrate; contacting the coated substrate with an aqueous base solution, wherein the exposed portion of the photoresist layer is removed from the coated substrate, thereby forming a patterned photoresist layer on the material layer; and transferring the pattern in the photoresist layer to the material layer.

### Brief Description of the Drawings

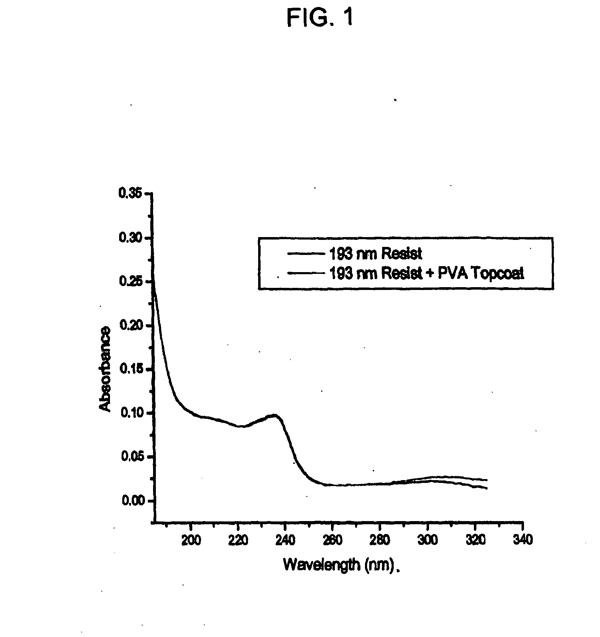

The sole figure, FIG. 1, is a graph plotting absorbance (nm) v. wavelength (sec) illustrating the absorbance for both 193 nm photoresist and 193 nm photoresist with poly vinyl alcohol (PVA) topcoat atop.

### Detailed Description of the Invention

The present invention is directed to a topcoat material comprising a polymer which is sparingly soluble or insoluble in water at a temperature of 25°C or below, but soluble in water at temperature of 60°C or above. The polymer comprises a repeating unit with poly vinyl alcohol moieties and poly vinyl acetate or poly vinyl ether moieties therein. The phrase "sparingly soluble" as used herein denotes that less than 1 weight percent and greater than 0.1 weight percent polymer dissolves in the solvent. The term "insoluble" as used herein denotes solubility less than "sparingly soluble". The phrase "soluble" as used herein denotes that greater than 5 weight percent of polymer will dissolves in the solvent.

The inventive topcoat material is soluble in water at a temperature of about 60°C or above, but sparingly soluble or insoluble in water at room temperature so that it is used for 193 nm immersion lithography. By "room temperature", it is meant a temperature ranging from 20°C to 25°C. Additionally, the topcoat material of the present invention can be adjusted to act as a TARC so that improved process control of image formation can be achieved. For 193 nm immersion lithography using water as the exposure medium, the optimal refractive index for a TARC material is 1.5 to 1.7.

The present invention is also directed to a topcoat material comprising a polymer which comprises vinyl alcohol monomer units and poly vinyl acetate or poly vinyl ether monomer units having the following polymer structure: 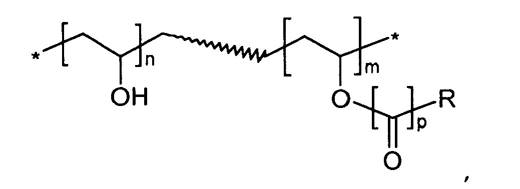 wherein R is an aliphatic or alicyclic radical; m and n are independently integers, and are the same or different; and p is zero or 1. When p is zero, R is directly attached to the oxygen atom via a covalent bond. The term "aliphatic" used herein denotes a hydrocarbon radical having carbon atoms linked in open chains. The term "alicyclic" used herein denotes a hydrocarbon radical that contains a ring but not aromatic. The term "hydrocarbon" used herein denotes an organic compound containing only carbon and hydrogen. Typical examples of the R group include, but not limit to: methyl, ethyl, propyl, isopropyl, butyl, isobutyl, cyclobutyl, pentyl, cyclopentyl, and hexyl. Preferably, R is an aliphatic or alicyclic radical having one to six carbon atoms.

The above-shown polymer has useful solubility in water. That is, the solubility of the polymer in water decreases as a result of hydrogen bonding that occurs within the polymer and increases as a result of the hydrogen bonding between the polymer and water. Thus, the performance of the polymer can be tuned by molecular weight and backbone composition. More specifically, higher polymer molecular weight results in lower solubility and greater degree of esterification results in higher solubility. Furthermore, depending on the molecular weight and backbone composition, the above-shown polymer is sparingly soluble or insoluble in water at room temperature, but is highly soluble in water at elevated temperatures, such as a temperature of 60°C or above. It is preferable that the resulting polymer solutions are stable at room temperature. By "stable"; it is meant that the polymer does not precipitate out of the solution when the solution stands at room temperature. The solubility properties and water permeabilities of the above-mentioned polymers are well known in the art, thus it is understood to one skilled in the art that the solubility properties and water permeabilities of this type of polymers can be 'tuned' through modifying the polymer composition, adjusting the polymer molecular weight, and using crosslinking agents.

The topcoat material of the present invention is coated to have a thickness from 20 nm to 100 nm, preferably from 50 nm to 80 nm. The above-mentioned polymers are soluble in hot water, so that the topcoat material can be stripped with hot water during the resist develop step. By "hot water", it is meant water having a temperature of 60°C or above. Preferably, the topcoat material can be completely stripped by hot water within the standard development time.

In particular, the topcoat material and portions of the photoresist layer are removed by contacting the resist layer with water at 60° or above. Moreover, the above-mentioned polymer is preferably substantially optically transparent to an appropriate exposure radiation for the underlying photoresist material, to allow patterning of the photoresist material. For use in coatings, the inventive polymer is most preferably substantially optically transparent at 193 nm.

It is preferable that the above-mentioned polymer has a refractive index in the range from 1.2 to 1.8. For 193 nm immersion lithography using water as the exposure medium, the refractive index of the polymer is most preferably in the range from 1.5 to 1.7.

It is also preferable that the polymer of the present invention has a tunable polymer molecular weight ranging from 10K to 250 K Daltons to enable the formulation of high solid content spin castable solutions with adequate viscosity. Since the mechanical durability of a coating improves upon increasing polymer molecular weight, it is especially preferable that the polymer has a high polymer molecular weight from 80 K to 200 K Daltons for use in coatings. Co-monomers can also be added to prepare copolymer materials with improved mechanical durability and to adjust the refractive index of the coating. Examples of such co-monomer units include, but are not limited to: acrylic aliphatic or alicyclic esters and aliphatic or alicyclic vinyl ethers, such as vinyl acetate, vinyl butyrate, vinyl propionate, methyl vinyl ether, ethyl vinyl ether, and vinyl halides.

In one exemplary embodiment, the topcoat polymer is Dupont Elvanol® of Grade 70-62 with 98.4-99.8% hydrolysis, which is a commercial polymer of very low cost. This Dupont Elvanol® was added into water having a temperature from 70°C to 100°C with stirring at a solids content of 1-10%, thereby forming a mixture. Hot filtration of the resulting mixture yielded a clear solution which was stable at room temperature, i.e., no polymer precipitation occurred on standing at room temperature. The resulting clear solution was applied on a silicon substrate to form a topcoat film having a thickness of about 20 to 100 nm when post-apply baked at temperatures of 130°C or above. The resulting topcoat film was insoluble in cold water, i.e., water at room temperature, but soluble in water at a temperature of 60°C or above. Chemical crosslinking agents, such as glyoxal can be used to lower the post-apply baked temperature required to insolubilize the topcoat film and minimize interactions between the topcoat film and the underlying resist film.

The optical properties of above topcoat film are well suited for immersion applications. FIG. 1, the sole figure of the present application, shows the absorbance for both 193 nm photoresist and 193 nm photoresist with PVA topcoat atop. Note that for a wide range of wavelength, the absorbance for both 193 nm photoresist and 193 nm photoresist with PVA topcoat atop are nearly identical demonstrating the topcoat film has desirable transparent quality for use in immersion applications.

In another aspect of the invention, the topcoat material may be used in a method of forming a patterned material layer on a substrate. The material layer may be, for example, a ceramic, dielectric, metal or semiconductor layer, such as those used in the manufacture of high performance integrated circuit devices and associated chip carrier packages.
Multilayers of such materials are also contemplated herein.

In the inventive method, a photoresist composition is first deposited on the substrate by known means, to form a photoresist layer on the material. The substrate with the photoresist layer may then be baked (post-apply bake, herein after "PAB") to remove any solvent from the photoresist composition and improve the coherence of the photoresist layer. Typical PAB baking temperature is 80° to 150°C. A typical photoresist thickness is 100 to 500 nm. Any suitable resist composition may be used, such as the resist composition disclosed in U.S. Patent Nos. 6,534,239 and 6,635,401 B2, and U.S. Patent 6949325.

In particular prior to pattern-wise exposure of to coated substrate to imaging radiation, an imaging medium is applied to the coated substrate.

Next, the topcoat material of the present invention is applied on the photoresist layer, thereby forming a coated substrate. For 1.0 to 5.0 wt% polymer solutions, a spin speed of 2-5 K RPM can result in 50 to 200 nm thick coatings. For a 125 mm wafer, the dispense volume can be in the range of 1 to 10 milliliters at room temperature. The coated substrate may then be baked (post-apply bake) to remove water from the topcoat material and improve the coherence of the coating layer. Typical softbaking temperature is from 100°C to 150°C. Typical post-apply baking time is 60 seconds. After the post-apply bake, spin cast films are sparingly soluble or insoluble in water at a temperature of 25°C or below. The coated substrate is then exposed to an appropriate radiation source through a patterned mask. In one exemplary embodiment, the imaging radiation is 193 nm radiation. In another embodiment, the imaging radiation is 157 nm radiation. In another embodiment, the imaging radiation is 248 nm radiation. The coated substrate also may be exposed to such imaging radiation using immersion lithography, wherein an imaging medium is applied to the coated substrate prior to exposure. In a preferred embodiment, the imaging medium is water. In another embodiment, the imaging medium is an organic liquid. Preferably, the organic liquid is a hydrocarbon or a substituted hydrocarbon. Most preferably, the organic liquid is an alicyclic hydrocarbon liquid. Typical examples of the organic liquid include : cyclooctane. The exposed substrate may then be baked (post-exposure bake) to improve the coherence of the photoresist and coating layers. Typical post-exposure baking temperature is determined by the properties of the photoresist. Those ordinarily skilled in the art can ascertain the necessary conditions without undue experiments.

The exposed substrate is then contacted with hot water, i.e., water having a temperature of 60°C or above, thereby removing the topcoat material from the coated substrate. Next, the exposed substrate is contacted with an aqueous base solution (developer), thereby removing the exposed portion of the photoresist layer. Preferred aqueous base solutions are aqueous alkaline solutions with the aqueous solutions of tetramethyl ammonium hydroxide more preferred. In one embodiment of the present invention, aqueous tetramethyl ammonium hydroxide at 0.2 N is used to remove the exposed portion of the photoresist layer. Contact with an aqueous base solution forms a patterned photoresist layer on the material layer.

The pattern in the photoresist layer may then be transferred to the material layer on the underlying substrate. Typically, the transfer is achieved by reactive ion etching or some other etching technique. The method of the invention may be used to create patterned material layer structures such as metal wiring lines, holes for contacts or vias, insulation sections (e.g., damascene trenches or shallow trench isolation), and trenches for capacitor structures, as might be used in the design of integrated circuit devices.

In particular, the transfer of the pattern in the photoresist layer to the material layer is by removal of portions of the material layer not covered by the patterned photoresist layer.

The processes to make these (ceramic, dielectric, metal or semiconductor) features generally involve providing a material layer or section of the substrate to be patterned, applying a layer of photoresist over the material layer or section, applying a top coat layer on the layer of photoresist, pattern-wise exposing the top coat and photoresist layers to radiation, post-exposure baking the exposed resist, developing the pattern by contacting the exposed top coat and photoresist with a developer, etching the layer(s) underlying the photoresist layer at spaces in the pattern whereby a patterned material layer or substrate is formed, and removing any remaining photoresist from the substrate. In some instances, a hard mask may be used below the photoresist layer to facilitate transfer of the pattern to a further underlying material layer or section. It should be understood that the invention is not limited to any specific lithography technique,or device structure.

### Example 1:

A silicon wafer coated with a conventional 193 nm antireflective layer (AR 40) was coated with a commercial photoresist JSR ARF AR237J-27 traderame) with a post apply bake of 130°C for 60 seconds.

A solution of 5 wt% poly(vinyl alcohol) (99% hydrolyzed, average Mw 124,000-186,000) in de-ionized water was applied to give a coating thickness of 230 nm after a post apply bake of 140°C for 60 seconds. Rinsing with water at 20°C caused essentially no thickness loss of the poly(vinyl alcohol) coating. The wafer was exposed in a 193 nm stepper and post exposure baked at 130°C for 60 seconds. The poly(vinyl alcohol) topcoat layer was stripped by treatment with water at 70°C for 60 seconds. Finally the imaged wafer was treated with .26N TMAH developer to develop the exposed resist. The contrast curve and exposure dose requirement for the photoresist with the poly(vinyl alcohol) topcoat was essentially unchanged from that obtained from the resist without topcoat.

### Example 2:

Using the process described in Example 1, JSR ARF AR414J-28 gave essentially the same results with little or no change in the contrast curve or exposure dose with a poly(vinyl alcohol) topcoat invention.

## Claims

1. A topcoat material for 193 nm immersion lithography for applying on top of a photoresist layer, comprising a polymer which is sparingly soluble or insoluble in water at a temperature of 25°C or below, but soluble in water at a temperature of 60°C or above,
wherein sparingly soluble denotes that less than 1 weight percent and greater than 0.1 weight percent polymer dissolves in water, insoluble denotes solubility less than sparingly soluble, and soluble denotes that greater than 5 weight percent of polymer will dissolve in water,
wherein the polymer comprises poly vinyl alcohol monomer units and poly vinyl acetate or polyvinyl ether monomer units providing the following polymer structure: 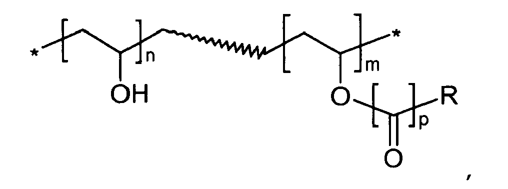 wherein R is an aliphatic or alicyclic radical; m and n are independently integers, and are the same or different; and p is zero or 1.

2. The topcoat material of Claim 1, wherein the polymer has a refractive index in the range from 1.2 to 1.8.

3. The topcoat material of Claim 1, wherein the polymer has a tunable molecular weight ranging from 10 K Daltons to 250 K Daltons.

4. A method of forming a patterned material layer on a substrate, the method comprising:
providing a substrate having a material layer on a surface thereof;
depositing a photoresist composition on the substrate to form a photoresist layer on the material;
applying a topcoat material as claimed in claim 1 on top of the photoresist layer, thereby forming a coated substrate;
pattern-wise exposing the coated substrate to an imaging radiation;
contacting the coated substrate with water at a temperature of 60°C or above, wherein the top coat material is removed from the coated substrate;
contacting the coated substrate with an aqueous base solution, wherein the exposed portion of the photoresist layer is removed from the coated substrate, thereby forming a patterned photoresist layer on the material layer; and
transferring the pattern in the photoresist layer to the material layer.

5. The method of Claim 4, wherein the topcoat material and portions of the photoresist layer are removed by contacting the resist layer with water at a temperature of 60°C or above.

6. The method of Claim 4, wherein the material layer is selected from the group consisting of ceramic, dielectric, metal and semiconductor layer.

7. The method of Claim 4, wherein the imaging radiation is one of 193 nm radiation, 157 nm radiation, or 248 nm radiation.

8. The method of Claim 4, further comprising, prior to pattern-wise exposing the coated substrate to imaging radiation, the step of applying an imaging medium to the coated substrate.

9. The method of Claim 8, wherein the imaging medium is water.

10. The method of claim 8 wherein the imaging medium is an organic liquid.

11. The method of claim 8 wherein the imaging medium is an alicyclic hydrocarbon liquid.

12. The method of Claim 4, wherein the pattern in the photoresist layer is transferred to the material layer by removing portions of the material layer not covered by the patterned photoresist layer.

13. The method of Claim 4, wherein the aqueous base solution is an aqueous solution of tetramethyl ammonium hydroxide.

## Patentansprüche

1. Deckschichtmaterial für die Immersionslithographie bei 193 nm zum Aufbringen auf die Oberseite einer Photoresistschicht, welches ein Polymer umfasst, welches bei einer Temperatur von 25 °C oder weniger in Wasser schwer löslich oder unlöslich ist, bei einer Temperatur von 60 °C oder mehr jedoch in Wasser löslich ist, wobei schwer löslich bedeutet, dass sich weniger als 1 Gewichtsprozent und mehr als 0,1 Gewichtsprozent des Polymers in Wasser löst, unlöslich eine geringere Löslichkeit als schwer löslich bedeutet und löslich bedeutet, dass sich mehr als 5 Gewichtsprozent des Polymers in Wasser lösen, wobei das Polymer Polyvinylalkohol-Monomereinheiten und Polyvinylacetat- oder Polyvinylether-Monomereinheiten umfasst, wodurch die folgende Polymerstruktur bereitgestellt wird: 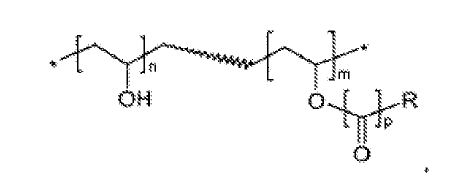 wobei R für einen aliphatischen oder alicyclischen Rest steht; m und n für unabhängige ganze Zahlen stehen, welche dieselben Zahlen oder verschiedene Zahlen sind; und p für Null oder 1 steht.

2. Deckschichtmaterial nach Anspruch 1, wobei das Polymer einen Brechungsindex im Bereich von 1,2 bis 1,8 aufweist.

3. Deckschichtmaterial nach Anspruch 1, wobei das Polymer ein einstellbares Molekulargewicht im Bereich von 10 kDalton bis 250 kDalton aufweist.

4. Verfahren zur Bildung einer Schicht eines strukturierten Materials auf einem Substrat, wobei das Verfahren das Folgende umfasst:
Bereitstellen eines Substrats, welches auf einer Fläche desselben eine Materialschicht aufweist;
Abscheiden einer Photoresist-Zusammensetzung auf dem Substrat, um eine Photoresistschicht auf dem Material zu bilden;
Aufbringen eines Deckschichtmaterials nach Anspruch 1 auf die Oberseite der Photoresistschicht, wodurch ein beschichtetes Substrat gebildet wird;
Strukturiertes Bestrahlen des beschichteten Substrats mit einer bilderzeugenden Strahlung;
In-Kontakt-Bringen des beschichteten Substrats mit Wasser bei einer Temperatur von 60 °C oder mehr, wobei das Deckschichtmaterial von dem beschichteten Substrat entfernt wird;
In-Kontakt-Bringen des beschichteten Substrats mit einer wässrigen Basenlösung, wobei der bestrahlte Abschnitt der Photoresistschicht von dem beschichteten Substrat entfernt wird, wodurch eine strukturierte Photoresistschicht auf der Materialschicht gebildet wird; und
Übertragen der Struktur in der Photoresistschicht auf die Materialschicht.

5. Verfahren nach Anspruch 4, wobei das Deckschichtmaterial und Abschnitte der Photoresistschicht entfernt werden, indem die Resistschicht bei einer Temperatur von 60 °C oder mehr mit Wasser in Kontakt gebracht wird.

6. Verfahren nach Anspruch 4, wobei die Materialschicht aus der Gruppe ausgewählt wird, die aus einer Keramikschicht, einer Dielektrikumsschicht, einer Metallschicht und einer Halbleiterschicht besteht.

7. Verfahren nach Anspruch 4, wobei es sich bei der bilderzeugenden Strahlung entweder um eine 193-nm-Strahlung, eine 157-nm-Strahlung oder eine 248-nm-Strahlung handelt.

8. Verfahren nach Anspruch 4, welches vor dem strukturierten Bestrahlen des beschichteten Substrats mit der bilderzeugenden Strahlung ferner den Schritt des Aufbringens eines Bilderzeugungsmediums auf das beschichtete Substrat umfasst.

9. Verfahren nach Anspruch 8, wobei es sich bei dem Bilderzeugungsmedium um Wasser handelt.

10. Verfahren nach Anspruch 8, wobei es sich bei dem Bilderzeugungsmedium um ein organisches fließfähiges Medium handelt.

11. Verfahren nach Anspruch 8, wobei es sich bei dem Bilderzeugungsmedium um ein fließfähiges alicyclisches Kohlenwasserstoffmedium handelt.

12. Verfahren nach Anspruch 4, wobei die Struktur in der Photoresistschicht auf die Materialschicht übertragen wird, indem Abschnitte der Materialschicht entfernt werden, die nicht von der strukturierten Photoresistschicht bedeckt sind.

13. Verfahren nach Anspruch 4, wobei es sich bei der wässrigen Basenlösung um eine Tetramethylammoniumhydroxid-Lösung handelt.

## Revendications

1. Matériau de couche supérieure pour une lithographie par immersion à 193 nm destiné à être appliqué sur la partie supérieure d'une couche de résine photosensible, comprenant un polymère qui est faiblement soluble ou insoluble dans l'eau à une température de 25 °C ou moins, mais soluble dans l'eau à une température de 60 °C ou plus,
où l'expression faiblement soluble signifie qu'un polymère à moins de 1 pourcent en poids et à plus de 0,1 pourcent en poids se dissout dans l'eau, le terme insoluble signifie une solubilité inférieure à faiblement soluble, et le terme soluble signifie que plus de 5 pourcent en poids du polymère se dissoudront dans l'eau,
où le polymère comprend des unités monomères de poly(alcool vinylique) et des unités monomères de poly(acétate de vinyle) ou de poly(éther de vinyle) fournissant la structure de polymère suivante : 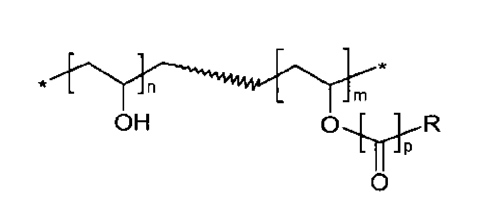 où R est un radical aliphatique ou alicyclique, m et n sont des nombres entiers indépendants et sont identiques ou différents, et p vaut zéro ou 1.

2. Matériau de couche supérieure selon la revendication 1, dans lequel le polymère présente un indice de réfraction dans la plage de 1,2 à 1,8.

3. Matériau de couche supérieure selon la revendication 1, dans lequel le polymère présente une masse atomique pouvant être ajustée allant de 10 kDa à 250 kDa.

4. Procédé de formation d'une couche de matériau dotée d'un motif sur un substrat, le procédé comprenant les étapes consistant à :
fournir un substrat comportant une couche de matériau sur sa surface,
déposer une composition de résine photosensible sur le substrat pour former une couche de résine photosensible sur le matériau,
appliquer un matériau de couche supérieure selon la revendication 1 sur la partie supérieure de la couche de résine photosensible, en formant de cette manière un substrat revêtu,
exposer la totalité du motif du substrat revêtu à un rayonnement de formation d'image,
mettre en contact le substrat revêtu avec de l'eau à une température de 60 °C ou plus, où le matériau de couche supérieure est retiré du substrat revêtu,
mettre en contact le substrat revêtu avec une solution de base aqueuse, où la partie exposée de la couche de résine photosensible est retirée du substrat revêtu, en formant de cette manière une couche de résine photosensible dotée d'un motif sur la couche de matériau, et
transférer le motif de la couche de résine photosensible sur la couche de matériau.

5. Procédé selon la revendication 4, dans lequel le matériau de couche supérieure et des parties de la couche de résine photosensible sont retirés par contact de la couche de résine photosensible avec de l'eau à une température de 60 °C ou plus.

6. Procédé selon la revendication 4, dans lequel la couche de matériau est sélectionnée à partir du groupe constitué d'une couche de céramique, de diélectrique, de métal et à semiconducteur.

7. Procédé selon la revendication 4, dans lequel le rayonnement de formation d'image est un rayonnement parmi le rayonnement à 193 nm, le rayonnement à 157 nm ou le rayonnement à 248 nm.

8. Procédé selon la revendication 4, comprenant en outre, avant l'exposition de la totalité du motif du substrat revêtu à un rayonnement de formation d'image, l'étape consistant à appliquer un support de formation d'image au substrat revêtu.

9. Procédé selon la revendication 8, dans lequel le support de formation d'image est de l'eau.

10. Procédé selon la revendication 8, dans lequel le support de formation d'image est un liquide organique.

11. Procédé selon la revendication 8, dans lequel le support de formation d'image est un liquide d'hydrocarbure alicyclique.

12. Procédé selon la revendication 4, dans lequel le motif de la couche de résine photosensible est transféré sur la couche de matériau en retirant des parties de la couche de matériau non recouvertes par la couche de résine photosensible dotée d'un motif.

13. Procédé selon la revendication 4, dans lequel la solution de base aqueuse est une solution aqueuse d'hydroxyde d'ammonium de tétraméthyle.
